Europäisches Patentamt

European Patent Office

Office européen des brevets

(19)

(11) Numéro de publication: **0 158 559**
**B1**

# FASCICULE DE BREVET EUROPEEN

(12)

(45) Date de publication du fascicule du brevet:
**28.12.88**

(51) Int. Cl.⁴: **H 01 L 21/90**, H 01 L 23/52

(21) Numéro de dépôt: **85400575.8**

(22) Date de dépôt: **25.03.85**

(54) Procédé pour interconnecter les zones actives et/ou les grilles des circuits intégrés cmos.

(30) Priorité: **30.03.84 FR 8405052**

(43) Date de publication de la demande:
**16.10.85 Bulletin 85/42**

(45) Mention de la délivrance du brevet:
**28.12.88 Bulletin 88/52**

(84) Etats contractants désignés:
**CH DE GB IT LI NL**

(56) Documents cités:
**EP-A- 0 066 097**
**DE-A- 3 222 805**
**DE-A- 3 223 858**
**FR-A- 2 525 029**

**SOLID STATE TECHNOLOGY, volume 25, décembre
1982, pages 85-90, Port Washington, US; N.E. MILLER:
"CVD tungsten interconnect and contact barrier
technology for VLSI"**

(73) Titulaire: **COMMISSARIAT A L'ENERGIE ATOMIQUE,
31/33, rue de la Fédération, F-75015 Paris (FR)**

(72) Inventeur: **Hartmann, Joel, 13, rue de la Balmette,
F-38640 Claix (FR)**
Inventeur: **Jeuch, Pierre, 13, rue du Parc,
F-38170 Seyssins (FR)**

(74) Mandataire: **Mongrédien, André et al, c/o
BREVATOME 25, rue de Ponthieu, F-75008 Paris (FR)**

## Description

La présente invention a pour objet un procédé pour interconnecter les zones actives et/ou les grilles d'un circuit intégré CMOS. Ce procédé permet, en particulier, de réaliser des connexions à courte distance entre les sources et les drains des transistors MOS (métal-oxyde-semiconducteur) à canal N ou P entrant dans la constitution des circuits intégrés CMOS (MOS complémentaire) et aussi de connecter ces sources et/ou ces drains avec les grilles de ces mêmes transistors.

Les circuits intégrés CMOS, dont le plus simple est un inverseur, constitué uniquement d'un transistor à canal N et d'un transistor à canal P dont l'un est bloqué quand l'autre conduit et vice-versa, présentent l'avantage de consommer très peu d'énergie électrique. En revanche, ils présentent une faible densité d'intégration.

Cette densité d'intégration est liée en particulier à la nécessité de connecter fréquemment des régions de type N+ (source ou drain d'un transistor à canal N) et de régions de type P+ (source ou drain de transistor à canal P), cette nécessité s'expliquant par le fait que chaque porte élémentaire du circuit intégré comprend à la fois des transistors à canal N et des transistors à canal P.

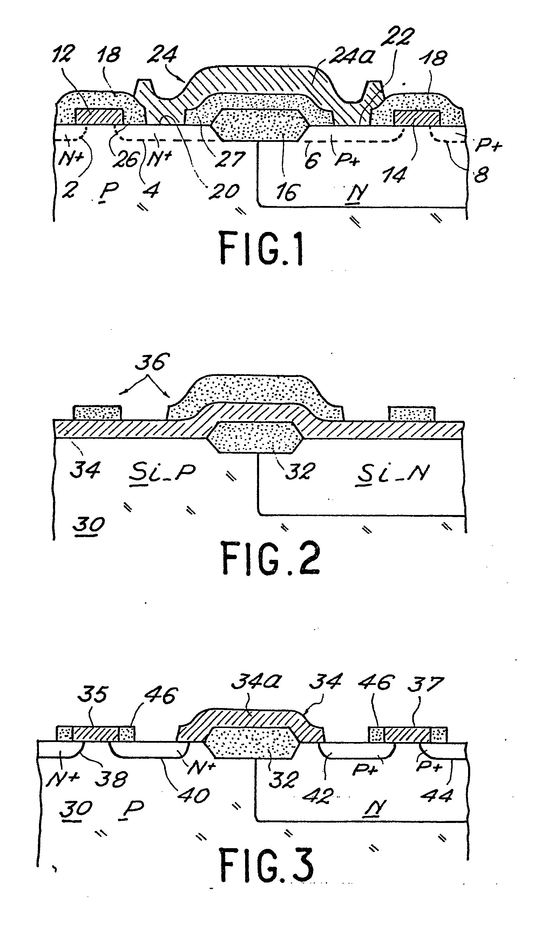

Sur la figure 1, on a représenté en coupe longitudinale un inverseur CMOS permettant d'illustrer le procédé de connexion de l'art antérieur.

Après avoir réalisé les éléments constitutifs du circuit intégré, c'est-à-dire les zones actives telles que les sources 2 et 8 et les drains 4 et 6, des transistors du circuit, les grilles 12 et 14 de ces transistors et l'oxyde de champ 16, on dépose sur l'ensemble du circuit intégré une couche d'isolant 18, généralement en oxyde de silicium, puis on grave cette couche d'isolant afin de réaliser les trous de contact électrique, tels que 20 et 22, des zones actives ainsi que ceux des grilles. Ensuite, on dépose sur la couche d'isolant gravée 18 une couche conductrice 24, généralement en aluminium, puis on grave celle-ci afin de réaliser les connexions voulues, telles que la connexion 24a entre le drain 4 du transistor à canal N et le drain 6 du transistor à canal P de l'inverseur.

Dans un tel procédé, outre la surface occupée par les connexions elles-mêmes, ce sont essentiellement les trous de contact électrique 20, 22 réalisés dans la couche d'isolant, et les gardes telles que 26 et 27 nécessaires pour le positionnement de ces trous qui réduisent la densité d'intégration du circuit intégré CMOS.

Afin d'augmenter la densité d'intégration de ces circuits CMOS, notamment en diminuant la surface occupée par les connexions, on réalise parfois des circuits à deux niveaux d'interconnexion, généralement en aluminium, mais ceci complique le procédé de fabrication des circuits de façon significative et ne permet pas, de toute façon, de supprimer les encombrements des trous de contact électrique, réalisés dans la couche d'isolant.

La présente invention a justement pour objet un procédé pour interconnecter les zones actives et/ou les grilles des circuits intégrés CMOS permettant de remédier à ces inconvénients et permettant notamment d'augmenter de façon notable la densité d'intégration de ces circuits.

Ce procédé permet en particulier, après avoir réalisé les éléments constitutifs du circuit intégré, telles que les zones actives, les grilles et l'oxyde de champ, de réaliser les différentes connexions voulues, sans avoir au préalable déposé sur l'ensemble du circuit intégré une couche isolante et réalisé dans cette couche les trous de contact électrique nécessaires pour réaliser les connexions.

De façon plus précise, l'invention a pour objet un procédé pour interconnecter les zones actives et/ou les grilles des circuits intégrés CMOS selon la revendication 1.

Le fait de supprimer, dans le procédé de l'invention, le dépôt de la couche d'isolant, lors de la réalisation des connexions des circuits intégrés CMOS, ainsi que le perçage des trous de contact électrique dans cette couche d'isolant, permet, par rapport aux procédés de l'art antérieur, d'augmenter de façon considérable la densité d'intégration de ces circuits.

Le procédé de l'invention peut être utilisé avantageusement pour effectuer des liaisons à courte distance, c'est-à-dire des liaisons entre les sources et drains et/ou les grilles des transistors des circuits intégrés CMOS.

Selon un mode particulier de mise en œuvre du procédé de l'invention, on effectue les étapes suivantes:

– définition des dimensions des connexions à réaliser et simultanément réalisation des grilles du circuit intégré dans la première couche conductrice,

– réalisation des zones actives par implantation ionique,

– dépôt de façon isotrope d'une couche d'isolant sur la structure obtenue,

– réalisation d'une gravure anisotrope de la couche d'isolant afin d'obtenir sur les flancs gravés de la première couche conductrice des bandes isolantes dont la largeur est définie par l'épaisseur de la couche d'isolant,

– élimination des bandes d'isolant se trouvant de part et d'autre des connexions à réaliser en gardant notamment celles se trouvant sur les flancs des grilles, et

– dépôt sélectif sur l'ensemble du circuit intégré, excepté sur les bandes d'isolant restantes, de la deuxième couche conductrice.

De façon avantageuse, les zones actives étant réalisées dans un substrat en silicium monocristallin, la première couche conductrice en silicium polycristallin, et les isolations latérales des grilles en oxyde de silicium, on effectue le dépôt de la deuxième couche conductrice par un dépôt chimique en phase vapeur de tungstène dans des conditions telles que le tungstène se dépose sélectivement sur les zones actives et la première couche conductrice et non pas sur les isolations latérales.

Par ailleurs, afin d'éviter des risques de courts-circuits entre les sources ou les drains du circuit intégré et le substrat de ce circuit, notamment au bord de l'oxyde de champ, on peut, avantageusement, réaliser dans les zones actives à connecter une implantation ionique, après avoir isolé latéralement les grilles du circuit.

D'autres caractéristiques et avantages de l'invention ressortiront mieux de la description qui va suivre, donnée à titre illustratif et non limitatif, en référence aux figures annexées, dans lesquelles:

– la figure 1, déjà décrite, représentant en coupe longitudinale un inverseur CMOS, illustre le procédé d'interconnexion d'un tel circuit selon l'art antérieur, et

– les figures 2 à 6 illustrent, en coupe longitudinale, les différentes étapes du procédé de connexion de l'invention selon un mode particulier de mise en œuvre.

Ce procédé va être décrit pour connecter le drain d'un transistor à canal N avec le drain d'un transistor à canal P, ces deux transistors constituant un inverseur CMOS. Bien entendu, ceci n'est qu'un exemple de connexions réalisable avec le procédé de l'invention, tout autre type de connexions et en particulier celui permettant de connecter les grilles des transistors du circuit intégré aux sources et/ou aux drains de ces mêmes transistors peut être envisagé.

Sur les figures 2 à 6, on a représenté un substrat semiconducteur 30, réalisé notamment en silicium monocristallin, comportant une région de type P dans laquelle sera réalisé le transistor à canal N de l'inverseur et une région de type N dans laquelle sera réalisé le transistor à canal P de ce même inverseur, ainsi que l'oxyde de champ 32 du circuit intégré. Cet oxyde de champ 32, réalisé par exemple selon la technologie LOCOS (oxydation localisée) a été représenté partiellement enterré dans le substrat semiconducteur 30, mais bien entendu, il pourrait ne pas être du tout enterré.

Après avoir réalisé sur le substrat 30 une couche d'oxyde, non représentée dans le but d'une simplification des schémas et constituant l'oxyde de grille, on dépose sur l'ensemble du circuit intégré, comme représenté sur la figure 2, une couche conductrice 34, dite première couche, réalisée par exemple en silicium polycristallin. Cette couche 34, déposée par exemple par la technique de dépôt chimique en phase vapeur, peut présenter une épaisseur de 0,4 µm.

On définit ensuite, dans la couche conductrice 34, notamment par gravure de cette couche, les dimensions des connexions à réaliser et notamment celles de la connexion du drain du transistor à canal N au drain du transistor à canal P. Cette gravure peut être effectuée au moyen d'un masque 36 réalisé dans une couche de résine, selon les procédés classiques de la photolithographie, représentant, entre autres, l'image de la connexion à réaliser, et en éliminant, comme représenté sur la figure 3, les parties de la couche conductrice 34 dépourvues de masque. Cette élimination peut se faire par exemple par attaque chimique, notamment avec KOH comme agent d'attaque lorsque cette couche 34 est réalisée en silicium ou par gravure ionique réactive avec de l'hexafluorure de soufre. Ensuite, on élimine le masque de résine 36, par exemple au moyen d'un plasma d'oxygène.

Sur la figure 3, la région de la couche conductrice 34 permettant de définir les dimensions de la connexion à réaliser porte la référence 34a.

La gravure de la couche conductrice 34 permet, de plus, de réaliser simultanément les grilles des transistors du circuit intégré, telles que les grilles 35 et 37 respectivement du transistor à canal N et du transistor à canal P de l'inverseur CMOS, la dimension de ces grilles étant définie par le masque 36.

Après gravure de la couche conductrice 34, on réalise classiquement les zones actives du circuit intégré, dans le substrat semiconducteur 30 par implantations ioniques successives. Ces implantations sont réalisées en masquant à chaque fois les régions complémentaires du substrat, afin d'obtenir des zones 38 et 40 de type N+, constituant respectivement la source et le drain du transistor à canal N, et des zones 42 et 44 de type P+, constituant respectivement la source et le drain du transistor à canal P.

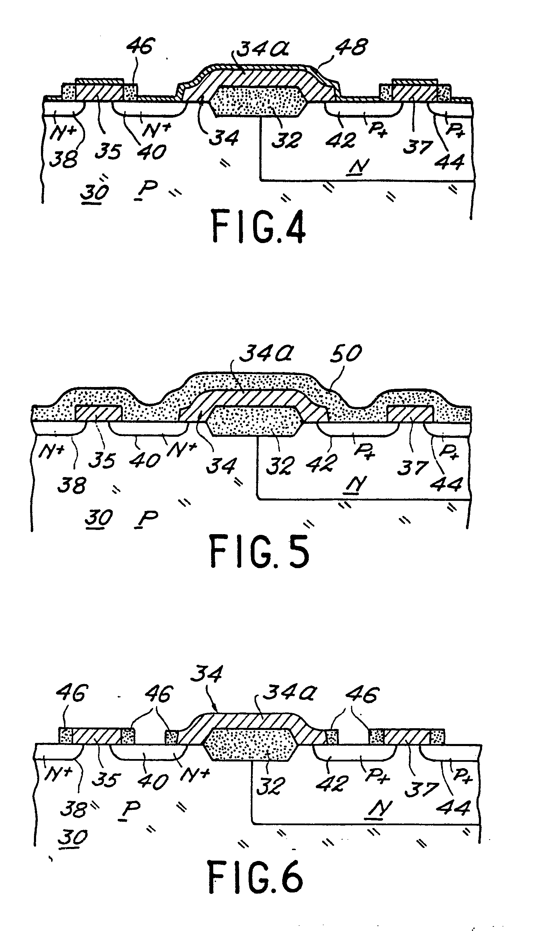

Après la réalisation des zones actives 38, 40, 42 et 44 de l'inverseur, on effectue une isolation latérale des grilles 35 et 37 ayant la forme de bandes isolantes 46. Ces bandes, réalisées de préférence en oxyde de silicium peuvent présenter une largeur de 0,25 µm. L'obtention de cette isolation latérale sera décrite ultérieurement en référence aux figures 5 et 6.

Après cette isolation latérale 46 des grilles, on effectue, éventuellement, dans les zones actives à connecter, telles que les drains 40 et 42, respectivement, des transistors à canal N et à canal P, de nouvelles implantations ioniques. Ces implantations, réalisées en masquant à chaque fois les régions complémentaires de type N+ et P+, permettent d'éviter la formation de courts-circuits entre les sources, les drains et le substrat, notamment au bord de l'oxyde de champ. Elles permettent aussi d'obtenir au niveau des grilles 35 et 37 du circuit intégré une double jonction de sources et drains, ce qui permet de diminuer le champ électrique entre les drains et les grilles adjacentes des transistors du circuit. Les implantations sont par exemple réalisées avec de l'arsenic, avec une énergie de 130 keV et une dose de $5.10^{15}$ atomes/cm$^2$ pour les zones N+ et du BF$_2$ avec une énergie de 40 keV et une dose de $3.10^{15}$ atomes/cm$^2$ pour les zones P+.

Après ces implantations, on dépose comme représenté sur la figure 4, une couche conductrice 48 sur l'ensemble du circuit intégré, excepté sur les bandes isolantes 46, c'est-à-dire en particulier sur les grilles 35 et 37 et la région 34a de la couche conductrice 34, ainsi que sur les zones N+ 38 et 40 et les zones P+ 42 et 44.

De préférence, cette couche conductrice 48, réalisant la connexion entre les drains 40 et 42 respectivement du transistor à canal N et du transistor à canal P, est réalisée en tungstène. Le dépôt de cette couche de tungstène avantageusement par un procédé de dépôt chimique en phase vapeur (CVD ou LPCVD), de façon que le tungstène se dépose sélectivement sur les zones en silicium monocristallin et polycristallin et non pas sur les régions oxydées. Cette couche présente notamment une épaisseur de 0,1 µm.

Le dépôt par CVD ou LPCVD d'une couche conductrice 48 en W permet d'obtenir directement, c'est-à-dire sans masquage ni gravure, les connexions voulues, et notamment la connexion des drains 40 et 42 de l'inverseur, lorsque les bandes isolantes 46 sont réalisées en oxyde de silicium, la couche conductrice 34 en silicium polycristallin et les zones actives telles que les drains 40 et 42 réalisées dans un substrat 30 en silicium monocristallin. Un tel dépôt a été décrit dans l'article de MILLER et al. dans «Solid State Technology de décembre 1982, intitulé «CVD Tungstène Interconnect and Contact Barrier Technology for VLSI».

Ce procédé de dépôt sélectif présente l'avantage de réaliser un auto-alignement de la connexion à réaliser sur les zones actives à connecter. Il permet aussi de façon auto-alignée de réaliser sur les grilles du circuit intégré telles que 35 et 37, les shunts de celles-ci.

On va maintenant décrire, en référence aux figures 5 et 6, un mode particulier de réalisation des isolations latérales des grilles du circuit intégré.

Après avoir réalisé les zones actives du circuit, on dépose de façon isotrope sur l'ensemble du circuit intégré, comme représenté sur la figure 5, par exemple par la technique de dépôt chimique en phase vapeur, une couche d'isolant 50 réalisée notamment en oxyde de silicium. Cette couche isolante 50 présente notamment une épaisseur de 0,25 µm.

Ensuite, on grave cette couche d'isolant 50 comme représenté sur la figure 6, de façon anisotrope, c'est-à-dire suivant une seule direction de l'espace, jusqu'à ce que les zones actives notamment 38, 40, 42 et 44 et les grilles 35 et 37 du circuit intégré soient mises à nu. Cette gravure anisotrope permet de ne laisser de la couche d'isolant 50 que les zones 46 situées sur les flancs gravés de la couche conductrice 34, c'est-à-dire sur les flancs des grilles 35 et 37 et de la région 34a de cette couche. Cette gravure peut être réalisée par exemple à l'aide d'un procédé de gravure ionique réactive. Un tel procédé de gravure permet d'obtenir des flancs isolants 46 dont la largeur est définie par l'épaisseur de la couche isolante 50. En conséquence, le dépôt isotrope d'une couche isolante 50 de 0,25 µm permet d'obtenir par ce procédé de gravure des bandes isolantes 46 de 0,25 µm de large.

Pour de plus amples détails, sur la façon de réaliser les bandes isolantes 46, on peut se référer au brevet français n° 2 525 029 déposé le 8 avril 1982 au nom du demandeur. Il est à noter que ce mode d'obtention de bandes isolantes n'est qu'un exemple particulier.

Après réalisation d'un masque de résine de forme appropriée sur la structure obtenue, on élimine localement les bandes d'isolant 46, en protégeant en l'occurrence celles se trouvant sur les flancs des grilles des transistors telles que 35 et 37, et en éliminant en particulier celles se trouvant sur les flancs de la région 34a de la couche conductrice correspondante destinée à connecter la zone N+ 40 à la zone P+ 42. Cette élimination peut, notamment, se faire par attaque chimique, par exemple avec de l'acide fluorhydrique lorsque ces bandes isolantes sont en SiO$_2$.

La structure du circuit, après cette élimination correspond à celle représentée sur la figure 3.

Le procédé de l'invention décrit ci-dessus permet de connecter différentes zones actives d'un circuit intégré telles que les drains, les sources et/ou les grilles des circuits intégrés CMOS, en augmentant de façon considérable la densité d'intégration de ces circuits par rapport aux procédés de l'art antérieur dans la mesure où l'on supprime pour ces connexions la réalisation, dans l'art antérieur, des trous de contacts dans la couche isolante ainsi que la métallisation d'aluminium et sa gravure. De plus, il permet de réaliser simultanément aux connexions les shunts des grilles de ces circuits, ces connexions et ces shunts étant par ailleurs auto-alignés respectivement sur les zones actives et les grilles correspondantes.

Le procédé de l'invention est surtout applicable à des connexions à courte distance. Pour la réalisation de connexions à longue distance des circuits intégrés, on peut utiliser les procédés de connexions de l'art antérieur.

**Revendications**

1. Procédé pour interconnecter des zones actives d'un circuit intégré CMOS, formées dans un substrat semi-conducteur, pour former le shunt des grilles du circuit et éventuellement pour connecter des grilles auxdites zones actives, comprenant les étapes successives suivantes:

(a) dépôt d'une première couche conductrice (34) sur le substrat (30),

(b) réalisation sur la première couche conductrice d'un masque (36) définissant simultanément les dimensions des connexions à réaliser et les dimensions des grilles dudit circuit,

(c) élimination des régions de la première couche conductrice non recouvertes du masque, formant ainsi les grilles (35, 37) du circuit et l'image (34a) des connexions à réaliser,

(d) élimination du masque,

(e) réalisation des zones actives (38, 40, 42, 44) du circuit par dopage local du substrat (30),

(f) dépôt d'une couche isolante (50) sur la structure obtenue en (e),

(g) réalisation d'une gravure anisotrope de la couche d'isolant (50) afin d'obtenir sur tous les flancs gravés de la première couche conductrice (34) des bandes isolantes (46) constituant les isolations latérales du circuit et d'éliminer tout isolant au-dessus des grilles et des images (34a) des connexions à réaliser,

(h) élimination des bandes isolantes (46) se trouvant uniquement de part et d'autre de l'image (34a) des connexions à réaliser, et (i) dépôt directement sur l'ensemble de la structure obtenue en (h), excepté sur les bandes d'isolant (46) restantes, d'une seconde couche conductrice (48) réalisant les connexions voulues et le shunt des grilles.

2. Procédé selon la revendication 1, caractérisé en ce que les zones actives (38, 40, 42, 44) sont formées par implantation d'ions dans le substrat (30).

3. Procédé selon la revendication 1 ou 2, caractérisé en ce que le dépôt de la couche isolante (50) est un dépôt isotrope, la largeur des bandes isolantes étant alors égale à l'épaisseur de la couche isolante.

4. Procédé selon l'une quelconque des revendications 1 à 3, caractérisé en ce que le substrat est en silicium monocristallin, la première couche conductrice (34) en silicium polycristallin, et les isolations latérales (46) des grilles en oxyde de silicium.

5. Procédé selon la revendication 4, caractérisé en ce que l'on effectue le dépôt de la deuxième couche conductrice (48) par un dépôt chimique en phase vapeur de tungstène de façon que celui-ci se dépose sélectivement sur les zones actives (38, 40, 42, 44) et la première couche conductrice (34) gravée et non pas sur les isolations latérales (46) des grilles.

6. Procédé selon l'une quelconque des revendications 2 à 5, caractérisé en ce que, entre les étapes (g) et (i), on réalise, dans les zones actives (38, 40, 42, 44), une implantation ionique additionnelle.

## Claims

1. Method for interconnecting the active zones of a C/MOS integrated circuit formed in a semiconductor substrate for forming the shunt of the gates of the circuit and optionally for connecting gates to said active zones, comprising the following successive stages:

(a) deposition of a first conductive layer (34) on substrate (30),

(b) formation on the first conductive layer of a mask (36) simultaneously defining the dimensions of the connections to be made and the dimensions of the gates of said circuit,

(c) elimination of the regions of the first conductive layer not covered by the mask, thus forming the gates (35, 37) of the circuit and the image (34a) of the connections to be formed,

(d) elimination of the mask,

(e) formation of the active zones (38, 40, 42, 44) of the circuit by local doping of the substrate (30),

(f) deposition of an insulating layer (50) on the structure obtained in (e),

(g) performing an anisotropic etching of the insulating layer (50) in order to obtain on all the etched flanks of the first conductive layer (34) insulating strips (46) constituting the lateral insulation of the circuit and eliminating all insulant above the gates and the images (34a) of the connections to be made,

(h) elimination of the insulating strips (46) located solely on either side of the image (34a) of the connections to be formed and

(i) direct deposition on the complete structure obtained in (h), except for on the remaining insulating strips (46), of a second conductive layer (48) producing the desired connections and the shunt of the gates.

2. Method according to claim 1, characterized in that the active zones (38, 40, 42, 44) are formed by ion implantation in the substrate (30).

3. Method according to claims 1 or 2, characterized in that the deposition of the insulating layer (50) is an isotropic deposition, the width of the insulating strips then being equal to the thickness of the insulating layer.

4. Method according to any one of the claims 1 to 3, characterized in that the substrate is of monocrystalline silicon, the first conductive layer (34) of polycrystalline silicon and the lateral insulation (46) of the gates of silicon oxide.

5. Method according to claim 4, characterized in that the deposition of the second conductive layer (48) takes place by chemical vapour phase deposition of tungsten, in such a way that the latter is selectively deposited on the active zones (38, 40, 42, 44) and the first etched conductive layer (34) and not on the lateral insulation (46) of the gates.

6. Method according to any one of the claims 2 to 5, characterized in that between stages (g) and (i) an additional ion implantation takes place in the active zones (38, 40, 42, 44).

## Patentansprüche

1. Verfahren zum Verbinden der aktiven Bereiche einer integrierten CMOS-Schaltung, die in einem Halbleitersubstrat ausgebildet sind, um den Nebenschlusswiderstand der Gates der Schaltung auszubilden und ggf. die Gates mit den aktiven Bereichen zu verbinden, enthaltend die folgenden aufeinanderfolgenden Schritte:

(a) Aufbringen einer ersten leitfähigen Schicht (34) auf dem Substrat (30),

(b) Ausbilden einer Maske (36) auf der ersten leitfähigen Schicht, die simultan die Abmessungen der herzustellenden Verbindungen und die Abmessungen der Gates der genannten Schaltung definiert,

(c) Beseitigen der von der Maske nicht bedeckten Bereiche der ersten leitfähigen Schicht, um auf diese Weise die Gates (35, 37) der Schaltung und das Muster (34a) der herzustellenden Verbindungen auszubilden,

(d) Entfernen der Maske,

(e) Erstellen der aktiven Bereiche (38, 40, 42, 44) der Schaltung durch örtliche Dotierung des Substrats (30),

(f) Aufbringen einer Isolierschicht (50) auf den im Schritt (e) erhaltenen Aufbau,

(g) Ausführung einer anisotropen Ätzung der Isolierschicht (50), um auf allen geätzten Flanken der ersten leitfähigen Schicht (34) Isolierbänder (46) zu erhalten, die die Querisolationen der Schaltung bilden, und Beseitigen der Isolierung über den Gates und den herzustellenden Verbindungsmustern (34a),

(h) Entfernen der Isolierbänder (46), die sich nur beiderseits des herzustellenden Verbindungsmusters (34a) befinden, und

(i) direktes Aufbringen auf die Gesamtanordnung der im Schritt (h) erhaltenen Struktur, mit Ausnahme der verbliebenen Isolierbänder (46) einer zweiten leitfähigen Schicht (48), die die gewollten Verbindungen und den Nebenschluss der Gates herstellt.

2. Verfahren nach Anspruch 1, dadurch gekennzeichnet, dass die aktiven Bereiche (38, 40, 42, 44) durch Ionenimplantation im Substrat (30) ausgebildet werden.

3. Verfahren nach Anspruch 1 oder 2, dadurch gekennzeichnet, dass die Isolierschicht (50) isotrop ist, so dass die Breite der isolierenden Bänder gleich der Dicke der Isolierschicht ist.

4. Verfahren nach einem der Ansprüche 1 bis 3, dadurch gekennzeichnet, dass das Substrat aus monokristallinem Silicium besteht, die erste leitfähige Schicht (34) aus polykristallinem Silicium besteht und die Querisolationen (46) der Gates aus Siliciumoxid bestehen.

5. Verfahren nach Anspruch 4, dadurch gekennzeichnet, dass die zweite leitfähige Schicht (48) durch chemischen Niederschlag von Wolfram in Dampfphase so ausgeführt wird, dass sich dieses selektiv auf den aktiven Bereichen (38, 40, 42, 44) und auf der geätzten ersten leitfähigen Schicht (34) und nicht auf den Querisolationen (46) der Gates niederschlägt.

6. Verfahren nach einem der Ansprüche 2 bis 5, dadurch gekennzeichnet, dass man zwischen den Schritten (g) und (i) in den aktiven Bereichen (38, 40, 42, 44) eine zusätzliche Ionenimplantation ausführt.

FIG.1

FIG.2

FIG.3

46    34a    48

N+    N+    34    32    42    P+    37    P+
38    35    40    34      N    44

30    P

FIG.4

34a    50

N+    35    40    N+    34    32    42    P+    37    P+
38                          N    44

30    P

FIG.5

46    46    34    34a    46

N+    35    40    N+    32    42    P+    37    P+
38    P                   N    44
30

FIG.6